(19) Europäisches Patentamt
European Patent Office
Office européen des brevets

(11) **EP 1 382 978 B1**

(12) **EUROPÄISCHE PATENTSCHRIFT**

(45) Veröffentlichungstag und Bekanntmachung des Hinweises auf die Patenterteilung:
**23.04.2008 Patentblatt 2008/17**

(51) Int Cl.:
***G01R 31/36*** *(2006.01)*

(21) Anmeldenummer: **03010649.6**

(22) Anmeldetag: **13.05.2003**

(54) **Verfahren zur Überwachung der Restladung einer Batterie**

Method for monitoring the residual charge of a battery

Procédé pour surveiller la charge résiduelle d'une batterie

(84) Benannte Vertragsstaaten:
**AT BE BG CH CY CZ DE DK EE ES FI FR GB GR HU IE IT LI LU MC NL PT RO SE SI SK TR**

(30) Priorität: **17.07.2002 DE 10232251**

(43) Veröffentlichungstag der Anmeldung:
**21.01.2004 Patentblatt 2004/04**

(73) Patentinhaber: **VB Autobatterie GmbH & Co. KGaA**
**30419 Hannover (DE)**

(72) Erfinder:
• **Bäuerlein, Peter, Dr. Dipl.-Chem.**
**29690 Lindwedel (DE)**

• **Helmker, Frank**
**30177 Hannover (DE)**
• **Meissner, Eberhard Dr.**
**31515 Wunstorf (DE)**
• **Koch, Ingo**
**31789 Hameln (DE)**

(74) Vertreter: **Gerstein, Hans Joachim et al**
**Gramm, Lins & Partner GbR**
**Theodor-Heuss-Strasse 1**
**38122 Braunschweig (DE)**

(56) Entgegenhaltungen:
**US-A- 4 947 124          US-A1- 2002 030 495**

EP 1 382 978 B1

## Beschreibung

Die Erfindung betrifft ein Verfahren zur Bestimmung der einer Speicherbatterie noch entnehmbaren Ladungsmenge.

Die Erfindung betrifft weiterhin eine Speicherbatterie mit Messmitteln und prozessorgesteuerten Auswertemitteln zur Durchführung des Verfahrens.

Durch den Gebrauch von wiederaufladbaren Speicherbatterien, insbesondere beim Entlade- und Ladebetrieb, tritt ein Verschleiß ein. Daneben gibt es auch andere, den Verschleiß von elektrochemischen Energiespeichern beschleunigende Betriebsbedingungen. Dazu gehört z. B. beim Bleiakkumulator die gesamte Betriebsdauer, d. h. die gesamte seit der Inbetriebnahme verstrichene Zeit einschließlich der Perioden, in denen der Akkumulator nicht elektrisch beaufschlagt wurde. Dieser Verschleiß wird noch verstärkt durch erhöhte Temperaturen. Erhöhte Temperaturen können aber nicht nur den Verschleiß während Perioden ohne elektrischer Beaufschlagung beschleunigen, sondern den durch zyklischen Entlade- und Ladebetrieb hervorgerufenen Verschleiß verstärken.

Bei einer Speicherbatterie drückt sich der Verschleiß unter anderem in einer Minderung der Speicherfähigkeit für elektrische Ladung aus, so dass sich die entnehmbare Ladungsmenge ausgehend von dem Vollladezustand nicht einfach bestimmen lässt.

Die entnehmbare Ladungsmenge $Q_{Rest}$ der Speicherbatterie ist hierbei die Ladungsmenge, die ausgehend vom aktuellen Zustand der Speicherbatterie unter Nennbedingungen noch entnommen werden kann. Im Neuzustand der Speicherbatterie ist die Summe aus entnehmbarer Ladungsmenge und entladener Ladungsmenge die Speicherfähigkeit im Neuzustand.

Die Speicherfähigkeit im Neuzustand ist die tatsächliche Speicherfähigkeit eines neuwertigen, ungebrauchten Energiespeichers.

Die entladende Ladungsmenge ist die Ladungsmenge, die ausgehend vom vollgeladenen Zustand einer Speicherbatterie unter Nennbedingungen entnommen werden muss, um den aktuellen Ladezustand zu erreichen.

Als aktuelle Speicherfähigkeit ist die Ladungsmenge ausgedrückt in Ah definiert, die einem nach Vorschrift vollgeladenen Energiespeicher unter Nennbedingungen entnommen werden kann. Diese Größe ändert sich mit der Gebrauchsdauer im allgemeinen mit fallender Tendenz.

Als Nenn-Speicherfähigkeit ist der Nominalwert der Speicherfähigkeit definiert, den der Hersteller der Speicherbatterie angibt. Unter Minderung der Speicherfähigkeit wird die Differenz zwischen aktueller Speicherfähigkeit und Speicherfähigkeit im Neuzustand verstanden.

In dem US-Patent 5,721,688 ist eine Vorrichtung und ein Verfahren zur Messung elektrischer Kenngrößen eines Energieversorgungssystems mit einer Spannungsmessvorrichtung, einer steuerbaren Stromquelle bzw. Stromsenke und mit einem Mikrocomputer beschrieben. Mit Hilfe des Mikrocomputers wird die Stromquelle bzw. Stromsenke so gesteuert, dass mindestens ein bestimmtes Stromprofil auf das Energieversorgungssystem aufgeprägt wird. Mit der Spannungsmesseinrichtung wird dann die Spannungsantwort auf das Stromprofil gemessen und hieraus eine elektrische Kenngröße ermittelt, wobei eine der Kenngrößen mindestens der Innenwiderstand des Energieversorgungssystems ist. Der Innenwiderstand wird aus der Spannungsdifferenz des Spannungsabfalls beim Widerstand unter Testbedingungen und des Spannungsabfalls bei Überlagerung des im Betriebszustand fließenden Stroms mit einem Teststrom bestimmt.

In dem US-Patent 5,572,136 ist eine elektronische Vorrichtung zum Testen von Speicherbatterien beschrieben, mit der ein relativ kleiner zeitveränderlicher Strom einer Speicherbatterie aufgeprägt und die zeitabhängige Spannungsantwort der Speicherbatterie beobachtet wird. Mit Hilfe eines Mikroprozessors wird aus der Spannungsantwort die Leitfähigkeit der Speicherbatterie ermittelt. Zudem kann das beobachtete Niveau der Spannungsantwort mit einem Referenzwert verglichen werden, um eine Qualitätsbewertung der Speicherbatterie abzuleiten. Hierbei wird der Verlauf der Spannungsantwort aufgezeichnet und ausgewertet. Dies ist relativ aufwendig und führt zu Ungenauigkeiten bei der Ableitung einer vergleichsfähigen Kenngröße.

In der DE 93 21 638 U1 ist ein elektronischer Batterietester zum Testen einer elektrochemischen Speicherbatterie beschrieben, die einen dynamischen Parameter (Leitwert oder Widerstand) aufweist. Der Batterietester hat Mittel zum Messen dieses dynamischen Parameters. Weiterhin wird die Leerlaufspannung gemessen und der gemessene dynamische Parameterwert in Bezug auf den Ladezustand durch Anpassung an die Leerlaufspannung korrigiert.

In dem US-Patent 5,680,050 ist ein Verfahren zur Erkennung des Batteriezustands beschrieben, bei dem ein Korrekturwert basierend auf einem durchschnittlichen Entladestrom für einen Zeitraum bestimmt wird, der größer als derjenige Zeitraum ist, der die Entladepolarisation in einen stationären Zustand bringt. Die Kapazität der Speicherbatterie im vollgeladenen Zustand wird mit dem Korrekturwert multipliziert und der Energieverbrauch der Batterie von der verfügbaren Entladekapazität zur Bestimmung einer verfügbaren Reservekapazität subtrahiert.

Die vorbeschriebenen Verfahren und Vorrichtungen dienen zur Ermittlung aktueller elektrischer Kenngrößen einer Speicherbatterie hinsichtlich des Leitwerts bzw. Innenwiderstands. Mit Hilfe der Verfahren können teilweise auch entnehmbare Entladekapazitäten einer Speicherbatterie in Abhängigkeit des Ladestroms bestimmt werden. Hierzu muss jedoch die Kapazität der vollgeladenen Speicherbatterie bekannt sein.

In der DE 691 31 276 T2 ist darüberhinaus ein elektronisches Testgerät zum Bewerten der prozentualen Energiekapazität einer Speicherbatterie oder einer Batteriezelle beschrieben. Hierbei wird der dynamische Leitwert bestimmt und zu einem Referenzleitwert, der dem Leitwert einer Zelle bzw. Speicherbatterie mit einer Kapazität von 100 % entspricht, gesetzt. Mit dem Verfahren kann jedoch nicht die Gesamtkapazität einer vollgeladenen Speicherbatterie bestimmt und festgestellt werden, ob eine Kapazitätsänderung durch Alterung der Speicherbatterie oder durch betriebsbedingte Entladung erfolgte. Zudem können aus dem zeitlichen Gang der Messwerte über einen längeren Zeitraum keine Informationen über den Verschleißzustand der Speicherbatterie erhalten werden. Als Maß für einen Batterieverschleiß ist der dynamische Leitwert nur begrenzt aussagekräftig.

US 2002/0030495 A1 offenbart ein Verfahren zum Testen von Bleiakkumulatoren durch Beaufschlagung von Strompulsen. Die Spannungsantwort wird zur Bestimmung der Nennkapazität ausgewertet.

Das US-Patent 4,947,124 offenbart ein Verfahren zur Bestimmung des Ladezustands einer Speicherbatterie, die mit Rechteck-Strompulsen beaufschlagt wird. Die Spannung vor Beendigung des Strompulses wird gemessen. Anschließend erfolgt eine Beaufschlagung mit einem höheren Strompuls. Kurz nach dem Beginn und am Ende des höheren Strompulses wird die Spannung wiederum gemessen. Weiterhin wird in den darauf folgenden Ruhephasen an zwei Punkten die Spannung gemessen. Aus den Messungen werden die internen Widerstände bestimmt und Differenzwiderstände aus der Differenz der gemessenen Widerstände berechnet.

Aufgabe der Erfindung war es daher, ein verbessertes Verfahren zur Bestimmung der einer Speicherbatterie noch entnehmbaren Ladungsmenge $Q_{Rest}$ zu schaffen, wenn diese Speicherbatterie nicht mehr im Neuzustand ist.

Die Aufgabe wird erfindungsgemäß gelöst durch das Verfahren mit den Merkmalen des Anspruchs 1 und durch die Speicherbatterie mit den Merkmalen des Anspruchs 33. Vorteilhafte Ausführungsformen sind in den Unteransprüchen beschrieben.

Im Unterschied zu den bekannten Verfahren wird vorgeschlagen, die einer Speicherbatterie noch entnehmbaren Ladungsmenge aus einer Differenzwiderstandskenngröße anhand einer Spannungsantwort auf mindestens einen Gleichstrompuls zu berechnen und nicht, wie beispielsweise in dem US-Patent 5,721,688 beschrieben, aus dem Innenwiderstand.

Die Ermittlung der Differenzwiderstandskenngröße erfolgt auch nicht auf der Basis eines dynamischen Leitwerts, sondern aus der Auswertung des zeitlichen Verlaufs der Spannungsantwort, wobei lediglich charakteristische Punkte der Spannungsantwort und nicht der gesamte Verlauf ausgewertet werden müssen.

Mit dem vorliegenden Verfahren ist es nunmehr möglich, auf einfache Weise durch Aufprägen einer kleinen umgesetzten Ladung mittels Gleichstrompulsen eine Aussage über die Speicherfähigkeit der Speicherbatterie und damit über die noch entnehmbare Ladungsmenge zu erhalten.

Die zur Berechnung der Differenzwiderstandskenngröße RD verwendeten Spannungs-/Stromwertepaare sind vorzugsweise zu mindestens einem ersten Zeitpunkt $t_1$ aufgenommen, der in der Ruhephase der Speicherbatterie liegt, sowie mindestens zu einem späteren Zeitpunkt $t_2$ in der durch Polarisation der Speicherbatterie geprägten Phase der Spannungsantwort. Es wurde erkannt, dass durch In-Beziehung-Setzen der Spannungs-/Stromwertepaare in diesen beiden Phasen, der Ruhephase und der Polarisationsphase, eine Differenzwiderstandskenngröße RD bestimmt werden kann, die ein Maß für die noch entnehmbare Ladungsmenge ist.

Dabei liegt der erste Zeitpunkt $t_1$ vorzugsweise unmittelbar vor einem Strompuls einer vorderen Strompulsflanke und der zweite Zeitpunkt $t_2$ nach einer vorderen Strompulsflanke des abklingenden Strompulses.

Die entnehmbare Ladungsmenge wird somit nicht nur aus einem Differenzquotienten, sondern aus einer Vielzahl von Differenzquotienten gewonnen, die beispielsweise durch Mittelung der Menge der Differenzquotienten in die Differenzwiderstandskenngröße RD umgerechnet werden. Die Mittelung kann beispielsweise linear erfolgen.

Aus der Differenzwiderstandskenngröße RD kann weiterhin vorteilhafterweise die Verminderung der Speicherfähigkeit der Speicherbatterie abgeleitet werden.

Die Differenzwiderstandskenngröße RD wird vorzugsweise nur aus den Spannungs-/Stromwertepaaren bestimmt, die bei vergleichbarem Ladezustand und/oder vergleichbarer Temperatur der Speicherbatterie gemessen wurden.

Weiterhin ist es vorteilhaft, die entnehmbare Ladungsmenge in Abhängigkeit von einem aktuellen Entladegrad DoD der Speicherbatterie zu bestimmen.

Unter technischen Randbedingungen, die einen Strompuls in Laderichtung erlauben, ist das Beaufschlagen der Speicherbatterie mit einer Folge von Strompulsen zu bevorzugen, wobei die Stromrichtung alternierend wechselt. Ist dies nicht möglich, so erfolgt die Bestimmung der noch entnehmbaren Ladungsmenge vorzugsweise durch einen oder mehrere Strompulse in Entladerichtung.

Der Betrag der Stromwerte für den aufgeprägten Strompuls ist vorzugweise kleiner als der 10-stündige Strom der analysierten Speicherbatterie, vorzugsweise jedoch kleiner als der 50-stündige Strom und noch bevorzugter kleiner als der 200-stündige Strom der Speicherbatterie.

Zwischen zwei Messungen von zwei Spannungs-/Stromwertepaaren sollte zudem eine Stromänderung erfolgen, deren Betrag größer als der 5000-stündige Wert des Stroms der Speicherbatterie, vorzugsweise jedoch größer als der 1000-stündige Wert des Stroms und bevorzugt größer als der 200-stündige Wert des Stroms der Speicherbatterie ist.

Zur Berechnung der Differenzwiderstandskenngröße RD werden zudem vorzugsweise nur solche Spannungs-/Stromwertepaare herangezogen, deren erstes Spannungs-/Stromwertepaar höchstens 10 Sekunden, vorzugsweise jedoch höchstens 1 Sekunde und besonders vorzugsweise höchstens 0,1 Sekunde unmittelbar vor einer Stromänderung des aufgeprägten Strompulses gemessen wurden.

Weiterhin ist es vorteilhaft, zur Berechnung der Differenzwiderstandskenngröße RD nur solche Spannungs-/Stromwertepaare zur Bildung der Differenzquotienten heranzuziehen, deren zweites Spannungs-/Stromwertepaar erst dann gemessen wurde, wenn das Zeitintegral über den fließenden Strom beginnend vom Zeitpunkt der Stromänderung ΔI nach der Messung des ersten Spannungs-/Stromwertepaares bis zum Zeitpunkt der Messung des zweiten Spannungs-/Stromwertepaares mindestens einen Wert von 0,01 mAs, vorzugsweise von 0,1 mAs und besonders vorzugsweise von nur 1 mAs pro einer Amperestunde Ah Speicherfähigkeit der Speicherbatterie beträgt. Die Werte des Zeitintegrals werden vorzugsweise in Abhängigkeit von der Temperatur der Speicherbatterie so gewählt, dass bei höheren Temperaturen größere Werte des Zeitintegrals und bei tieferen Temperaturen kleinere Werte des Zeitintegrals festgelegt werden.

Das den Spannungsantworten zur Berechnung einer Differenzwiderstandskenngröße RD zugrundegelegte Stromprofil sollte ungefähr vergleichbar sein. Insbesondere sollten die Stromänderungsraten der Stromänderung zwischen allen verwendeten Spannungs-/Stromwertepaaren, die Zeitdauern zwischen dem ersten Spannungs-/Stromwertepaar bis zur Stromänderung und die Zeitdauern zwischen der Stromänderung und dem jeweils zweiten Spannungs-/Stromwertepaar ungefähr gleich sein.

Das Stromprofil wird hierbei der Speicherbatterie durch eine elektrische Schalteinheit (aktiv oder passiv) aufgeprägt.

Weiterhin ist es vorteilhaft, die Differenzwiderstandskenngröße RD oder die entnehmbare Ladungsmenge $Q_{Rest}$ mit einem Schwellwert zu vergleichen und die Überschreitung des Schwellwertes, das Verhältnis zum Schwellwert oder die Abweichung vom Schwellwert anzuzeigen. Der Schwellwert kann hierbei beispielsweise von der Temperatur des Energiespeichers abhängig gewählt werden.

Weiterhin ist es vorteilhaft, die berechnete entnehmbare Ladungsmenge $Q_{Rest}$ mit einer Bestimmung des aktuellen Entladegrades DoD oder des aktuellen Ladezustandes SoC der Speicherbatterie zu verknüpfen und aus dieser Verknüpfung die gesamte aktuelle Speicherfähigkeit der Speicherbatterie zu ermitteln. Diese aktuelle Speicherfähigkeit kann angezeigt oder zur weiteren Auswertung verwendet werden.

Weiterhin kann die berechnete entnehmbare Ladungsmenge $Q_{Rest}$ mit einer Bestimmung des aktuellen Entladegrades DoD oder des aktuellen Ladezustands SoC verknüpft werden, um die in den Energiespeicher einladbare Ladungsmenge zu ermitteln, die ebenfalls angezeigt oder zur weiteren Auswertung verwendet werden kann.

Die gesamte aktuelle Speicherfähigkeit kann zusätzlich mit der Speicherfähigkeit im Neuzustand oder mit dem Nennwert der Speicherfähigkeit verknüpft werden, um hieraus eine Verschleißkenngröße zu ermitteln, die die Minderung der Speicherfähigkeit der Speicherbatterie ausdrückt. Diese Verschleißkenngröße kann angezeigt oder zur weiteren Berechnung verwendet werden. Vorzugsweise wird die Verschleißkenngröße mit einem Schwellwert verglichen und in Abhängigkeit von diesem Vergleich ein Hinweis auf den erforderlichen Austausch oder eine erforderliche Wartung des Energiespeichers vorgenommen.

Das beschriebene Verfahren kann weiterhin mit anderen Verfahren zur Ermittlung des Zustands der Speicherbatterie verknüpft werden, vorzugsweise mit Verfahren, die den Ladezustand und/oder die Leistungsfähigkeit ermitteln. Es kann ebenso eine Verknüpfung mit anderen Verfahren zur Ermittlung des Verschleißes der Speicherbatterie erfolgen, wobei die Verfahren andere zum Verschleiß von Speicherbatterien beitragende Effekte berücksichtigen.

Für die Vorhersage von Zuständen der Speicherbatterie ist es zudem vorteilhaft, aus den ermittelten Zustandswerten, insbesondere der entnehmbaren Ladungsmenge, Vorhersagen über das Verhalten der Speicherbatterie in anderen, als dem aktuellen Betriebszustand abzuleiten.

Das Verfahren ist insbesondere für Bleiakkumulatoren als Speicherbatterien geeignet.

Die Erfindung wird nachfolgend anhand der beigefügten Zeichnungen näher erläutert. Es zeigen:

Figur 1 -  Diagramm eines pulsförmigen Stromprofils mit einer Spannungsantwort zur Ermittlung der entnehmbaren Ladungsmenge;

Figur 2 -  Diagramm mit einem ausgewählten Strompuls und einer Spannungsantwort mit den zur Berechnung eines Differenzquotienten verwendeten Strom- und Spannungswerten;

Figur 3 -  Diagramm der Differenzwiderstandskenngröße RD über der entnommenen Kapazität einer neuwertigen Speicherbatterie bei verschiedenen Pulsdauern;

Figur 4 -  Diagramm von Differenzwiderstandskenngrößen RD über der entnommenen Kapazität für Speicherbatterien unterschiedlicher Kapazitäten aufgrund unterschiedlichen Alterungsgrades;

Figur 5 -     Diagramm eines galvanostatischen Doppelpulses mit zugehöriger Spannungsantwort zur Ermittlung einer Differenzwiderstandskenngröße RD;

Figur 6 -     Diagramm von Differenzwiderstandskenngrößen RD in Abhängigkeit von der entnommenen Kapazität bei Speicherbatterien unterschiedlicher Kapazitäten aufgrund unterschiedlichen Alterungsgrades mit t = 10 s;

Figur 7 -     Diagramm von Differenzwiderstandskenngrößen RD in Abhängigkeit von der entnommenen Kapazität bei Speicherbatterien unterschiedlicher Kapazitäten aufgrund unterschiedlichen Alterungsgrades mit t= 1000 s;

Figur 8 -     Diagramm von Differenzwiderstandskenngrößen RD in Abhängigkeit von der entnommenen Kapazität bei Speicherbatterien unterschiedlicher Alterungszustände mit unterschiedlicher noch entnehmbarer Kapazität mit t =30 s.

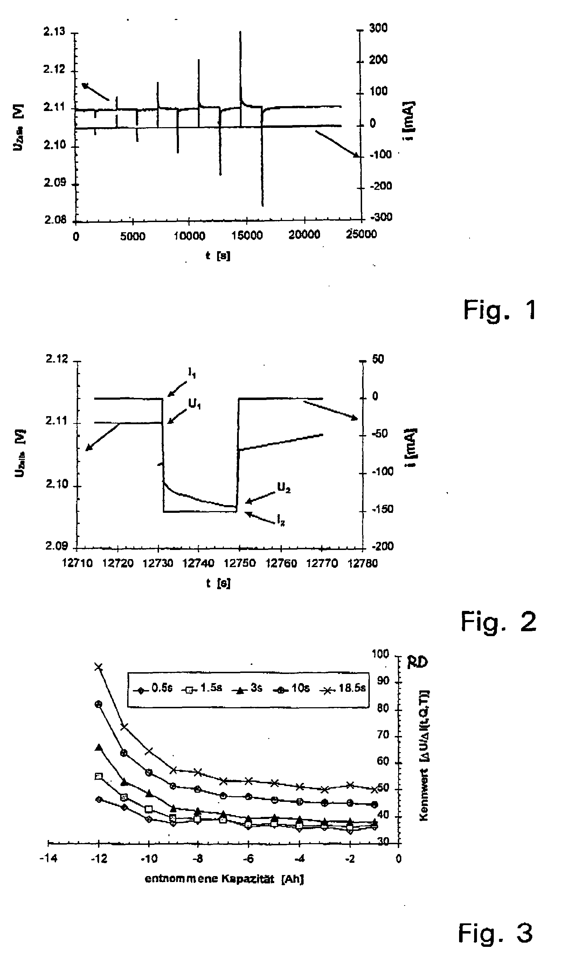

Die Figur 1 lässt ein Diagramm eines pulsförmigen Stromprofils I(t) über der Zeit t erkennen, das auf eine Speicherbatterie aufgeprägt wird. Das Stromprofil I (t) besteht aus Strompulsen I alternierender Stromrichtung. Die Höhe des aufgeprägten Stroms I nimmt hierbei pro Strompuls zu.

Zunächst befindet sich die Speicherbatterie im Ruhezustand. Anschließend wird zur Ermittlung der entnehmbaren Ladungsmenge $Q_{Rest}$ das folgende Stromprofil mit 5 Strompulsfolgen A, B, C, D und E wie folgt aufgeprägt:

Strompuls A1:     T = 18 s, I = + 20 mA;
Strompuls A2:     T = 1800 s, I = 0 mA;
Strompuls A3:     T = 18 s, I = - 20 mA;
Strompuls A4:     T = 1800 s, I = 0 mA;

Strompuls B1:     T = 18 s, I = + 40 mA;
Strompuls B2:     T = 1800 s, I = 0 mA;
Strompuls B3:     T = 18 s, I = - 40 mA;
Strompuls B4:     T = 1800 s, I = 0 mA;

Strompuls C1:     T = 18 s, I = + 80 mA;
Strompuls C2:     T = 1800 s, I = 0 mA;
Strompuls C3:     T = 18 s, I = - 80 mA;
Strompuls C4:     T = 1800 s, I = 0 mA;

Strompuls D1:     T = 18 s, I = + 150 mA;

(fortgesetzt)

Strompuls D2:     T = 1800 s, I = 0 mA;
Strompuls D3:     T = 18 s, I = - 150 mA;
Strompuls D4:     T = 1800 s, I = 0 mA;

Strompuls E1:     T = 18 s, I = + 250 mA;
Strompuls E2:     T = 1800 s, I = 0 mA;
Strompuls E3:     T = 18 s, I = - 250 mA;
Strompuls E4:     T = 1800 s, I = 0 mA.

Auf die aufgeprägten Ströme I folgt jeweils eine Spannungsantwort, die durch einen ausgeprägten Spannungssprung ΔU und eine nachfolgende Abklingphase gekennzeichnet ist.

Die Figur 2 lässt einen Ausschnitt des Diagramms aus der Figur 1 erkennen, dabei ist die Phase mit dem steilen Spannungs- und Stromanstieg zum Zeitpunkt von ungefähr t = 12.730 s bis etwa 12.732 s durch den ohmschen Widerstand der Speicherbatterie geprägt. Weitere Polarisationseffekte wirken sich dort noch nicht aus. Die nachfolgende Phase der Spannungsantwort ist hingegen durch die Polarisationseffekte der Speicherbatterie geprägt, in der der Spannungspuls U langsamer abfällt (negativer Strompuls) bzw. ansteigt (positiver Spannungspuls). Aus der Strom- und Spannungskurve werden mindestens zwei Spannungs-/Stromwertepaare $U_i$, $I_i$ ermittelt, wobei ein erster Zeitpunkt $t_1$ (~12.730 s) unmittelbar vor der ansteigenden Flanke der Spannungsantwort bzw. des Strompulses liegt. Ein zweiter Zeitpunkt $t_2$ (~12.748 s) liegt ungefähr am Ende des Strompulses, d. h. kurz vor der abfallenden Strom- bzw. Spannungsflanke. Aus den beiden Spannungs-/Stromwertepaaren $U_i$, $I_i$ zum Zeitpunkt $t_1$ und $t_2$ wird eine Differenzspannung und ein Differenzstrom nach der Formel

$$\Delta U = (U_i - U_j) = (U_1 - U_2)$$

$$\Delta I = (I_i - I_j) = (I_1 - I_2)$$

errechnet.

Aus der Differenzspannung ΔU und dem Differenzstrom ΔI wird die Differenzwiderstandskenngröße

$$RD = \frac{\Delta U}{\Delta I} \quad \text{berechnet.}$$

Diese Differenzwiderstandskenngröße RD ist ein charakteristischer Wert einer Speicherbatterie, der von der aktuellen noch entnehmbaren Ladungsmenge $Q_{Rest}$ der Speicherbatterie abhängt. Es hat sich gezeigt, dass die Differenzwiderstandskenngröße RD deutlich zunimmt, wenn die in der Speicherbatterie aktuell noch entnehmbare Ladungsmenge $Q_{Rest}$ einen gewissen Schwellenwert unterschreitet. Der Anstieg der Differenzwiderstandskenngröße RD kann dann zur weiteren Auswertung und/oder zur Auslösung einer Aktion benutzt werden.

Nachfolgend wurde eine Untersuchung von verschiedenen Bleiakkumulatoren beschrieben, die aus einer positiven Platte und zwei negativen Platten besteht. Dabei wurden positive Platten untersucht, die unterschiedlichen Vorbehandlungen unterworfen wurden, die zu einer Verminderung der Speicherfähigkeit der jeweiligen positiven Platte führten.

| Zelle Nr. | Kapazität in Ah | Vorbehandlung |
|---|---|---|
| 2 | 13,70 | Keine (neue Zelle) |
| 4 | 7,13 | Zyklen mit 50% Entladetiefe |
| 7 | 4,90 | Zyklen mit 17,5 % Entladetiefe |

Die Tests sind beschrieben in: "Lastenheft für PKW-Starterbatterien" vom Verband der deutschen Automobilindustrie (VDA) mit Überarbeitung vom 12.01.1997.

Bei einer entnehmbaren Ladungsmenge $Q_{Rest}$ unterhalb von 4 Ah weisen die untersuchten positiven Elektroden eine sehr ähnliche Differenzwiderstandskenngröße RD auf, die nur wenig vom Alterungszustand der untersuchten positiven Elektrode abhängt und damit zur Bestimmung der Ladungsmenge $Q_{Rest}$ genutzt werden kann, der der positiven Elektrode noch entnehmbar ist.

Die Differenzwiderstandskenngröße RD beträgt bei einer entnehmbaren Ladungsmenge $Q_{Rest}$ von ungefähr 3 Ah circa 70 mΩ. Bei einer neuwertigen positiven Elektrode (Zelle 2) etwa 74 mΩ, bei einer mit 120 Zyklen beaufschlagten positiven Elektrode (Zelle 4) etwa 77 mΩ und bei einer nach AK 3.4 gealterten positiven Elektrode (Zelle 7) etwa 78 mΩ.

Die Figur 3 zeigt den Zusammenhang zwischen der Differenzwiderstandskenngröße RD und der Kapazität einer neuwertigen positiven Elektrode in Abhängigkeit von der Pulsdauer. Dabei wird zur Bestimmung der Differenzwiderstandskenngröße RD nicht der Spannungswert $U_2$ am Ende des Strompulses, sondern der Spannungswert U nach unterschiedlichen Zeiten nach dem Einschalten des Strompulses I verwendet. Es wird deutlich, dass die Differenzwiderstandskenngröße RD somit auch von der Pulsdauer t abhängt. So steigt die Differenzwiderstandskenngröße RD umso mehr an, je größer die Pulsdauer ist.

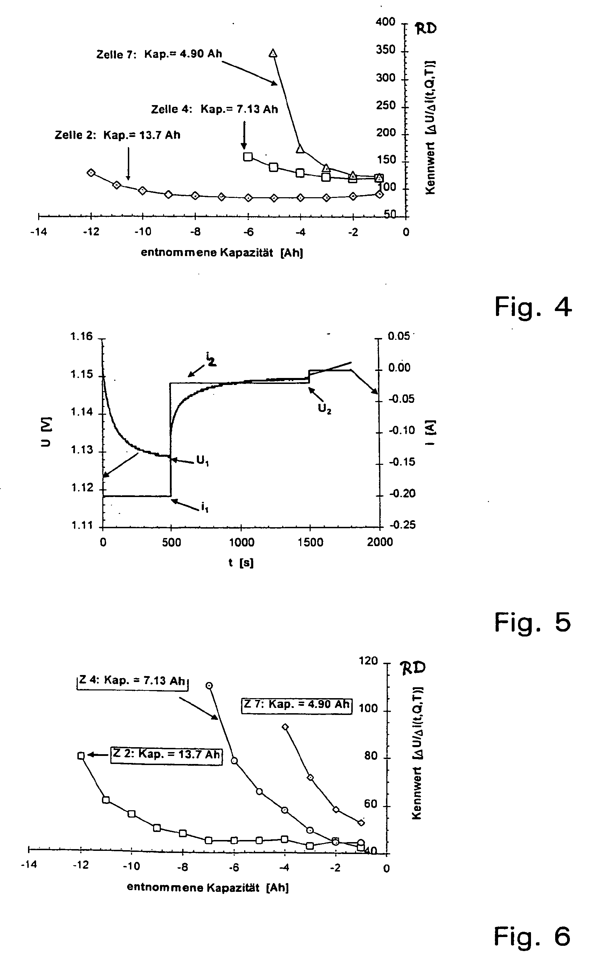

Die Figur 4 zeigt den Zusammenhang zwischen der Differenzwiderstandskenngröße RD und der entnommenen Kapazität einer neuwertigen positiven Elektrode. Es ist wiederum ein deutlicher Anstieg der Differenzwiderstandskenngröße RD beim Ende der Entladung zu erkennen. Jedoch weist die Zelle der Speicherbatterie mit einer neuwertigen positiven Elektrode insgesamt eine deutlich geringere Differenzwiderstandskenngröße RD auf, als die Zellen mit gealterter positiver Elektrode.

Die Figur 5 zeigt einen galvanostatischen Doppelpuls zur Ermittlung der Differenzwiderstandskenngröße. Anstelle der vorher beschriebenen Vielzahl einzelner Strompulse alternierender Stromrichtung kann auch ein galvanischer Doppelpuls ohne Wechsel der Stromrichtung eingesetzt werden, um die Differenzwiderstandskenngröße zu ermitteln.

Die Figur 6 zeigt die Abhängigkeit der Differenzwiderstandskenngröße RD von der entnommenen Kapazität der untersuchten Speicherbatterie-Zellen, wobei der zweite Spannungswert $U_2$ 10 Sekunden nach Aufbringen des Strompulses gemessen wurde.

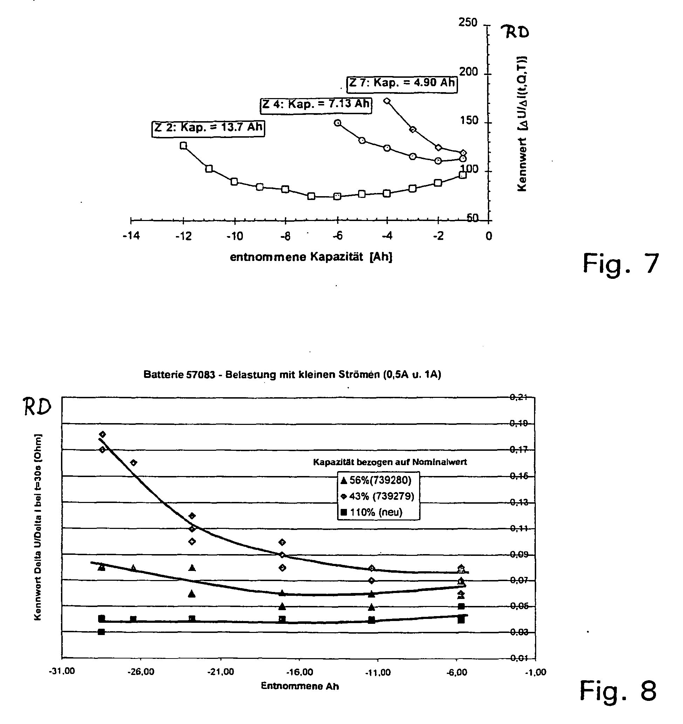

Im Vergleich hierzu zeigt die Figur 7 die Abhängigkeit der Differenzwiderstandskenngröße RD von der entnehmbaren Kapazität, wobei der zweite Spannungswert $U_2$ 1000 Sekunden nach Aufbringen des Strompulses ermittelt wurde.

Es wird deutlich, dass die Differenzwiderstandskenngrößen-Kurve bei $t_2$ = 10 s steiler verläuft, als bei $t_2$ = 1000 s. Die an der Speicherbatterie noch entnehmbare Ladungsmenge lässt sich damit für $t_2$ = 10 s zuverlässiger ermitteln, als bei größeren Zeitabständen.

Das Aufprägen eines Stromprofils I(t) erfolgt vorzugsweise durch ein elektronisches Steuergerät, wobei das Stromprofil I(t) weitgehend rechteckige Flanken haben sollte. Das Aufprägen des Stromprofils sollte in Betriebsphasen erfolgen, in denen die Speicherbatterie durch andere Komponenten nicht oder nur gering elektrisch belastet ist. Für in Kraftfahrzeugen eingesetzte Starterbatterien sollte die Messung vorzugsweise in der Standphase erfolgen, in der die Ruhestrombelastung in Entladerichtung im Bereich von etwa 10 bis 100 mA liegt.

Das Aufprägen des Stroms kann entweder durch das Steuergerät selbst erfolgen. Es kann aber auch eine Ansteuerung von Stromverbrauchern oder Stromquellen in einer solchen Weise erfolgen, dass sich für die Speicherbatterie das gewünschte Stromprofil ergibt. Alternativ kann auch ein weiterer Energiespeicher als Stromverbraucher bzw. Stromquelle verwendet werden, in der den Gleichstrompuls über einen DC/DC-Wandler einkoppelt.

Die Figur 8 zeigt den Zusammenhang von Differenzwiderstandskenngrößen RD für Starterbatterien unterschiedlicher Alterungszustände mit unterschiedlicher noch entnehmbarer Kapazität von 110 %, 54 % und 43 %.

Die Differenzwiderstandskenngrößen RD wurden mit Spannungs/Stromwertpaaren berechnet, wobei der zweite Spannungswert $U_2$ 30 Sekunden nach Aufbringen des Strompulses gemessen wurde.

Es ist erkennbar, dass eine Abhängigkeit zwischen der Differenzwiderstandskenngröße RD und der noch entnehmbaren Kapazität besteht. Das heißt, dass die Differenzwiderstandskenngröße RD ein Maß für die einer Speicherbatterie unter Nennbedingungen entnehmbaren Ladungsmenge $Q_{Rest}$ ist.

Um einen zuverlässig auswertbare Differenzwiderstandskenngröße RD zu erhalten, wird vorzugsweise bei mehreren Strompulsen Spannungs-/Stromwertpaare gemessen und hieraus jeweils Differenzquotienten

$$\left(\frac{\Delta U}{\Delta I}\right)_{ij} = \frac{\Delta U_{ij}}{\Delta I_{ij}}$$ gebildet. Aus der Menge der Differenzquotienten wird dann die Differenzwiderstandskenngröße RD beispielsweise durch geeignete Mittelungsverfahren, wie lineare Regression, gebildet.

Die Differenzquotienten können hierbei in Abhängigkeit von der Temperatur T der Speicherbatterie angepasst werden.

## Patentansprüche

1. Verfahren zur Bestimmung der einer Speicherbatterie noch entnehmbaren Ladungsmenge ($Q_{Rest}$), mit den Schritten:

    - Messen von Stromwerten ($I_i$) und Spannungswerten ($U_i$) an mindestens zwei Zeitpunkten ($t_i$) einer Spannungsantwort der Speicherbatterie auf einen oder mehrere Strompulse, wobei pro Zeitpunkt ($t_i$) ein Spannungs-/Stromwertepaar ($U_i, I_i$) erhalten wird;

    **gekennzeichnet durch** folgende Schritte:

    - für eine Folge von Strompulsen jeweils Bilden der Stromdifferenzen ($\Delta I_{ij} = I_i - I_j$) jeweils von zwei Stromwerten ($I_i$) und der Spannungsdifferenzen ($\Delta U_{ij} = U_i - U_j$) jeweils von zwei Spannungswerten ($\Delta U_i$),
    - Berechnen einer Menge von Differenzquotienten (($\Delta U/\Delta I)_{ij}$) jeweils als Quotient einer Spannungsdifferenz und der zugeordneten Stromdifferenz (($\Delta U/\Delta I)_{ij} = \Delta U_{ij}/\Delta I_{ij}$),
    - Bilden der Differenzwiderstandskenngröße (RD) aus der Menge von Differenzquotienten

    $$\left(\left(\frac{\Delta U}{\Delta I}\right)_{ij}\right), \text{ und}$$

    - Bestimmen der aus der Speicherbatterie noch entnehmbaren Ladungsmenge ($Q_{Rest}$) aus der Differenzwiderstandskenngröße (RD) durch eine vorgegebene Funktion oder eine abgespeicherte Wertetabelle zur Definition des Zusammenhangs zwischen Ladungsmengen ($Q_{Rest}$) und Differenzwiderstandskenngrößen (RD).

2. Verfahren nach Anspruch 1, **gekennzeichnet durch** Berechnung der Differenzwiderstandskenngröße (RD) **durch** Mittelung der Menge der Differenzquotienten (($\Delta U/\Delta I)_{ij}$).

3. Verfahren nach Anspruch 2, **gekennzeichnet durch** Mittelung **durch** lineare Mittelung.

4. Verfahren nach einem der vorhergehenden Ansprüche, **dadurch gekennzeichnet, dass** mindestens ein erster Zeitpunkt ($t_1$) in einer Ruhephase liegt, in der die Spannungsantwort nicht durch Polarisation geprägt ist und mindestens ein zweiter Zeitpunkt ($t_2$) in einer Polarisierungsphase liegt, in der die Spannungsantwort durch Polarisation geprägt ist.

5. Verfahren nach Anspruch 4, **dadurch gekennzeichnet, dass** der erste Zeitpunkt ($t_1$) vor einem Strompuls mit einer ansteigenden Strompulsflanke und später abfallenden Strompulsflanke und der zweite Zeitpunkt ($t_2$) nach der ansteigenden Strompulsflanke des Strompulses gewählt wird.

6. Verfahren nach einem der vorhergehenden Ansprüche, **dadurch gekennzeichnet, dass** die Differenzwiderstandskenngröße (RD) nur aus den Spannungs-/Stromwertepaaren ($U_i, I_i$) bestimmt wird, die bei vergleichbaren Ladezustand und/oder vergleichbarer Temperatur (T) der Speicherbatterie gemessen werden.

7. Verfahren nach einer der vorhergehenden Ansprüche, **gekennzeichnet durch** Messen der Temperatur (T) der Speicherbatterie und Bestimmen der entnehmbaren Ladungsmenge ($Q_{Rest}$) in Abhängigkeit von der Temperatur (T).

8. Verfahren nach Anspruch 7, **gekennzeichnet durch** Normieren der Differenzquotienten (($\Delta U/\Delta I)_{ij}$) auf eine Basistemperatur ($T_B$).

9. Verfahren nach einem der vorhergehenden Ansprüche, **gekennzeichnet durch** Beaufschlagen der Speicherbatterie mit einer Folge von Strompulsen, wobei die Stromrichtung der Strompulse alternierend wechselt.

10. Verfahren nach einem der vorhergehenden Ansprüche, **dadurch gekennzeichnet, dass** der Betrag der Stromwerte ($I_i$) kleiner als der 10-stündige Strom der Speicherbatterie ist.

11. Verfahren nach Anspruch 10, **dadurch gekennzeichnet, dass** der Betrag der Stromwerte ($I_i$) kleiner als der 50-stündige Strom der Speicherbatterie ist.

12. Verfahren nach Anspruch 10, **dadurch gekenn-**

**zeichnet, dass** der Betrag der Stromwerte ($I_i$) kleiner als der 200-stündige Strom der Speicherbatterie ist.

13. Verfahren nach einem der vorhergehenden Ansprüche, **dadurch gekennzeichnet, dass** zwischen zwei Messungen von zwei Spannungs-/Stromwertepaaren ($U_i$, $I_i$) eine Stromänderung ($\Delta I$) erfolgt, wobei der Betrag der Stromänderung ($\Delta I$) größer als der 5000-stündige Wert des Stromes der Speicherbatterie ist.

14. Verfahren nach Anspruch 13, **dadurch gekennzeichnet, dass** der Betrag der Stromänderung ($\Delta I$) größer als der 1000-stündige Wert des Stromes der Speicherbatterie ist.

15. Verfahren nach Anspruch 13, **dadurch gekennzeichnet, dass** der Betrag der Stromänderung ($\Delta I$) größer als der 200-stündige Wert des Stromes der Speicherbatterie ist.

16. Verfahren nach einem der vorhergehenden Ansprüche, **dadurch gekennzeichnet, dass** die Stromänderung ($\Delta I$) mit einer Stromänderungsrate $\left(\dfrac{\Delta I}{\Delta t}\right)$ erfolgt, die in ihrem Betrag größer als der 5000-stündige Strom der Speicherbatterie pro Sekunde ist.

17. Verfahren nach Anspruch 16, **dadurch gekennzeichnet, dass** die Stromänderungsrate $\left(\dfrac{\Delta I}{\Delta t}\right)$ größer als der 1000-stündige Strom pro Sekunde ist.

18. Verfahren nach Anspruch 16, **dadurch gekennzeichnet, dass** die Stromänderungsrate $\left(\dfrac{\Delta I}{\Delta t}\right)$ größer als der 200-stündige Strom pro Sekunde ist.

19. Verfahren nach einem der Ansprüche 4-5, **dadurch gekennzeichnet, dass** das erste Stromspannungs-/Stromwertepaar ($U_1$, $I_1$) zum ersten Zeitpunkt ($t_1$) höchstens 10 Sekunden, vorzugsweise höchstens 1 Sekunde und besonders vorzugsweise höchstens 0,1 Sekunde unmittelbar vor einer Stromänderung ($\Delta I$) gemessen wird.

20. Verfahren nach Anspruch 19**, dadurch gekennzeichnet, dass** das zweite Stromspannungs-/Stromwertepaar ($U_2$, $I_2$) zum zweiten Zeitpunkt ($t_2$) frühestens 0,1 Sekunde, vorzugsweise frühestens 1 Sekunde und besonders vorzugsweise frühestens 10 Sekunden nach der Stromänderung ($\Delta I$) gemessen wird.

21. Verfahren nach Anspruch 20, **dadurch gekennzeichnet, dass** die zeitlichen Abstände zwischen der Stromänderung ($\Delta I$) und der Messung des zweiten Spannungs-/Stromwertepaares ($U_2$, $I_2$) zum zweiten Zeitpunkt ($t_2$) temperaturabhängig sind, wobei der zeitliche Abstand bei höheren Temperaturen ($T$) größer als bei tieferen Temperaturen ($T$) ist.

22. Verfahren nach einem der vorhergehenden Ansprüche, **dadurch gekennzeichnet, dass** die Differenzwiderstandskenngröße (RD) nur aus zu zwei Zeitpunkten ($t_1$, $t_2$) gemessenen Spannungs-/Stromwertepaaren ($U_1$, $I_1$ und $U_2$, $I_2$) bestimmt wird, bei denen das zweite Spannungs-/Stromwertepaar ($U_2$, $I_2$) erst dann gemessen wurde, wenn das Zeitintegral über den fließenden Strom ($I$) beginnend vom Zeitpunkt einer Stromänderung ($\Delta I$) nach der Messung des ersten Spannungs-/Stromwertepaares ($U_1$, $I_1$) bis zum zweiten Zeitpunkt ($t_2$) der Messung des zweiten Spannungs-/Stromwertepaares ($U_2$, $I_2$) mindestens einen Wert von 0,01 mAs vorzugsweise von 0,1 mAs und besonders vorzugsweise von mindestens 1 mAs pro einer Amperestunde Speicherfähigkeit der Speicherbatterie beträgt.

23. Verfahren nach einem der vorhergehenden Ansprüche, **dadurch gekennzeichnet, dass** das ein annähernd einheitliches Stromprofil der für die Bestimmung der Differenzwiderstandskenngröße (RD) verwendeten Strompulse angewendet wird, wobei sich das Stromprofil aus den Stromänderungsraten $\left(\dfrac{\Delta I}{\Delta t}\right)$ der Stromänderung zwischen den zur Bestimmung verwendeten Spannungs-/Stromwertepaaren ($U_i$, $I_i$ und $U_j$, $I_j$), der Zeitdauer zwischen einem ersten Spannungs-/Stromwertepaar ($U_i$) bis zur Stromänderung ($\Delta I$) und der Zeitdauer zwischen der Stromänderung ($\Delta I$) und dem zweiten Spannungs-/Stromwertepaar ($U_2$, $I_2$) bestimmt.

24. Verfahren nach einem der vorhergehenden Ansprüche, **dadurch gekennzeichnet, dass** die Strompulse der Speicherbatterie durch eine elektrische Schalteinheit aufgeprägt werden.

25. Verfahren nach einem der vorhergehenden Ansprüche, **gekennzeichnet durch** Vergleichen der Differenzwiderstandskenngröße (RD) oder der entnehmbaren Ladungsmenge ($Q_{Rest}$) mit einem Schwellwert und Ausgeben einer Überschreitung des Schwellwertes, des Verhältnisses der Differenzwiderstandskenngröße (RD) oder der entnehmbaren Ladungsmenge ($Q_{Rest}$) zum Schwellwert und/oder der Abweichung der Differenzwiderstandskenngröße (RD) oder der entnehmbaren Ladungsmenge (Q$_{Rest}$) vom Schwellwert.

26. Verfahren nach Anspruch 25, **dadurch gekennzeichnet, dass** der Schwellwert in Abhängigkeit von der Temperatur (T) der Speicherbatterie definiert ist.

27. Verfahren nach einem der vorhergehenden Ansprüche, **gekennzeichnet durch** Ermittlung der gesamten aktuellen Speicherfähigkeit der Speicherbatterie und/oder der in die Speicherbatterie einladbaren Ladungsmenge **durch** Korrelation der berechneten entnehmbaren Ladungsmenge (Q$_{Rest}$) mit dem aktuellen Entladegrad (DoD) und/oder dem aktuellen Ladezustand (SoC).

28. Verfahren nach einem der vorhergehenden Ansprüche, **gekennzeichnet durch** Ermittlung einer Verschleißkenngröße zur Beschreibung der Minderung der Speicherfähigkeit der Speicherbatterie **durch** Korrelation der ermittelten gesamten aktuellen Speicherfähigkeit der Speicherbatterie mit der Speicherfähigkeit der Speicherbatterie im Neuzustand oder mit dem Nennwert der Speicherfähigkeit der Speicherbatterie im Neuzustand.

29. Verfahren nach Anspruch 28, **gekennzeichnet durch** Vergleichen der Verschleißkenngröße mit einem Schwellwert und Ausgeben einer Wartungsmeldung in Abhängigkeit von dem Vergleich.

30. Verfahren nach einem der vorhergehenden Ansprüche, **dadurch gekennzeichnet, dass** die Speicherbatterie ein Bleiakkumulator ist.

31. Verfahren nach einem der vorhergehenden Ansprüche, **gekennzeichnet durch** Verknüpfung der Berechnungsergebnisse mit anderen Zustandsgrößen der Speicherbatterie, beispielsweise mit dem Ladezustand und/oder der Leistungsfähigkeit der Speicherbatterie und/oder von Kenngrößen für Effekte, die zum Verschleiß einer Speicherbatterie beitragen.

32. Verfahren nach einem der vorhergehenden Ansprüche, **gekennzeichnet durch** Vorhersagen des Verhaltens der Speicherbatterie in einem anderen als dem aktuellen Betriebszustand.

33. Speicherbatterie mit Messmitteln und prozessorgesteuerten Auswertemitteln zur Durchführung des Verfahrens nach einem der vorhergehenden Ansprüche.

**Claims**

1. Method for determining the amount of charge (Q$_{Rest}$) which can still be drawn from an energy storage battery, **comprising the steps of:**

   - measurement of current values (I$_i$) and voltage values (U$_i$) at at least two times (t$_1$) in a voltage response of the energy storage battery to one or more current pulses, with one voltage/current value pair (U$_i$, I$_i$), being obtained for each time (t$_1$);

   **characterized by** the following steps:

   - formation of the current differences ($\Delta I_{ij} = I_i$-$I_j$) between in each case two current values (I$_i$) and of the voltage differences ($\Delta U_{ij} = U_I - U_j$) between in each case two voltage values ($\Delta U_i$) for a sequence of current pulses,
   - calculation of a set of difference quotients (($\Delta U/\Delta I)_{ij}$), in each case as the quotient of a voltage difference and of the associated current difference (($\Delta U/\Delta I)_{ij} = \Delta U_{ij}/\Delta I_{ij}$), and
   - formation of the resistance difference characteristic variable (RD) from the set of difference

   quotients $\left( \left( \dfrac{\Delta U}{\Delta I} \right)_{ij} \right)$, and

   - determination of the amount of charge (Q$_{Rest}$) which can still be drawn from the energy storage battery by means of a predetermined function or a stored value table for definition of the relationship between the amounts of charge (Q$_{Rest}$) and the resistance difference characteristic variables (RD).

2. Method according to claim 1, **characterized by** calculation of the resistance difference characteristic variable (RD) by forming the mean value of the set of difference quotients (($\Delta U/\Delta I)_{ij}$).

3. Method according to claim 2, **characterized by** forming the mean value by linear averaging.

4. Method according to one of the preceeding claims, **characterized in that** at least one time (t$_1$) occurs in a stationary phase whose voltage is not **characterized by** polarization, and at least one time (t$_2$) occurs in a polarization phase whose voltage is **characterized by** polarization.

5. Method according to claim 4, **characterized in that** the first time (t$_1$) is chosen before a current pulse with a front current pulse flank, and the second time (t$_2$) is chosen after the front current pulse flank of the current pulse.

6. Method according to one of the preceding claims, **characterized in that** the resistance difference characteristic variable (RD) is determined only from those voltage/current value pairs ($U_i$, $I_i$) which are measured for comparable states of charge and/or comparable temperatures (T) of the energy storage battery.

7. Method according to one of the preceding claims, **characterized by** measurement of the temperature (T) of the energy storage battery, and determination of the amount of charge ($Q_{Rest}$) which can still be drawn as a function of the temperature (T).

8. Method according to claim 7, **characterized by** normalization of the difference quotients (($\Delta U/\Delta I)_{ij}$) with respect to a basic temperature ($T_B$).

9. Method according to one of the preceding claims, **characterized by** application of a sequence of current pulses to the energy storage battery, with the current direction of the current pulses changing alternately.

10. Method according to one of the preceding claims, **characterized in that** the magnitude of the current values ($I_i$) is less than the 10-hour current of the energy storage battery.

11. Method according to claim 10, **characterized in that** the magnitude of the current values ($I_i$) is less than the 50-hour current of the energy storage battery.

12. Method according to claim 10, **characterized in that** the magnitude of the current values ($I_i$) is less than the 200-hour current of the energy storage battery.

13. Method according to one of the preceding claims, **characterized in that** a current change ($\Delta I$) takes place between two measurements of two voltage/current value pairs ($U_i$, $I_i$), with the magnitude of the current change ($\Delta I$) greater than the 5000-hour value of the current of the energy storage battery.

14. Method according to claim 13, **characterized in that** the magnitude of the current change ($\Delta I$) is greater than the 1000-hour value of the current of the energy storage battery.

15. Method according to claim 13, **characterized in that** the magnitude of the current change ($\Delta I$) is greater than the 200-hour value of the current of the energy storage battery.

16. Method according to one of the preceding claims, **characterized in that** the current change ($\Delta I$) takes place at a current rate of change $\left(\dfrac{\Delta I}{\Delta t}\right)$ whose magnitude is greater than the 5000-hour current of the energy storage battery per second.

17. Method according to claim 16, **characterized in that** the current rate of change $\left(\dfrac{\Delta I}{\Delta t}\right)$ is greater than the 1000-hour current per second.

18. Method according to claim 16, **characterized in that** the current rate of change $\left(\dfrac{\Delta I}{\Delta t}\right)$ is greater than the 200-hour current per second.

19. Method according to one of the claims 4 to 5, **characterized in that** the first current-voltage/current value pair ($U_1$, $I_1$) at the first time ($t_1$) was measured at most 10 seconds, preferably at most 1 second and particularly preferably at most 0.1 second, immediately before a current change ($\Delta I$).

20. Method according to claim 19, **characterized in that** the second current-voltage/current value pair ($U_2$, $I_2$) at the second time ($t_2$) was measured at the earliest 0.1 second, preferably at the earliest 1 second and particularly preferably at the earliest 10 seconds after the current change ($\Delta I$).

21. Method according to claim 20, **characterized in that** the time intervals between the current change ($\Delta I$) and the measurement of the second voltage/current value pair ($U_2$, $I_2$) at the second time ($t_2$) are temperature-dependent, with the time interval being greater for higher temperatures (T) than for lower temperatures (T).

22. Method according to one of the preceding claims, **characterized in that** the resistance difference characteristic variable (RD) is determined only from voltage/current value pairs ($U_1$, $I_1$ and $U_2$, $I_2$) which are measured at two times ($t_1$, $t_2$) and for which the second voltage/current value pair ($U_2$, $I_2$) was measured only when the time integral of the current (I) flowing, starting from the time of a current change ($\Delta I$) after the measurement of the first voltage/current value pair ($U_1$, $I_1$) to the second time ($t_2$) of the measurement of the second voltage/current value pair ($U_2$, $I_2$), has a value of at least 0.01 mAs, preferably 0.1 mAs and particularly preferably at least one 1 mAs per ampere hour of storage capacity of the energy storage battery.

**23.** Method according to one of the preceding claims, **characterized in that** the one approximately standard current profile of the current pulses which are used for determining the resistance difference characteristic variable (RD) is used, with the current profile being determined from the current rates of

change $\left(\dfrac{\Delta I}{\Delta t}\right)$ of the current change between the voltage/current value pairs (U$_i$, I$_i$ and U$_j$, I$_j$) used for determination, the time period between a first voltage/current value pair (U$_i$) and the current change ($\Delta$I), and the time period between the current change ($\Delta$I) and the second voltage/current value pair (U$_2$, I$_2$).

**24.** Method according to one of the preceding claims, **characterized in that** the current pulses are applied to the energy storage battery by means of an electrical switching unit.

**25.** Method according to one of the preceding claims, **characterized by** comparison of the resistance difference characteristic variable (RD) or of the amount of charge (Q$_{Rest}$) which can be drawn with a threshold value, and outputting of overshooting of the threshold value, of the ratio of the resistance difference characteristic variable (RD) or of the amount of charge (Q$_{Rest}$) which can be drawn to the threshold value, and/or of the discrepancy between the resistance difference characteristic variable (RD) or the amount of charge (Q$_{Rest}$) which can be drawn and the threshold value.

**26.** Method according to claim 25, **characterized in that** the threshold value is defined as a function of the temperature (T) of the energy storage battery.

**27.** Method according to one of the preceding claims, **characterized by** determination of the total present storage capacity of the energy storage battery and/or of the amount of charge with which the energy storage battery can be charged, by correlation of the calculated amount of charge (Q$_{Rest}$) which can be drawn with the present degree of discharge (DoD) and/or with the present state of charge (SoC).

**28.** Method according to one of the preceding claims, **characterized by** determination of a wear characteristic variable in order to describe the reduction in the storage capacity of the energy storage battery, by correlation of the determined total present storage capacity of the energy storage battery with the storage capacity of the energy storage battery when new, or with the nominal value of the storage capacity of the energy storage battery when new.

**29.** Method according to claim 28, **characterized by** comparison of the wear characteristic variable with a threshold value, and outputting of a servicing message as a function of the comparison.

**30.** Method according to one of the preceding claims, **characterized in that** the energy storage battery is a lead-acid rechargeable battery.

**31.** Method according to one of the preceding claims, **characterized by** the calculation results being linked to other state variables for the energy storage battery, for example to the state of charge and/or to the power capability of the energy storage battery and/or characteristic variables for effects which contribute to wear in an energy storage battery.

**32.** Method according to one of the preceding claims, **characterized by** prediction of the behavior of the energy storage battery in an operating state other than the present operating state.

**33.** Energy storage battery having measurement means and processor-controlled evaluation means for carrying out the method according to one of the preceding claims.

**Revendications**

**1.** Procédé de détermination de la quantité de charge (Q$_{Rest}$) qui peut encore être prélevée d'une batterie d'accumulateurs, comprenant les étapes consistant à :

- mesurer des valeurs de courant (I$_i$) et des valeurs de tension (U$_i$) à au moins deux instants (t$_i$) d'une réponse en tension de la batterie d'accumulateurs suite à une ou plusieurs impulsion(s) de courant, une paire de valeurs de tension/courant (U$_i$, I$_i$) étant obtenue par instant (t$_i$) ;

**caractérisé par** les étapes suivantes consistant à :

- pour une série d'impulsions de courant, former à chaque fois les différences de courant ($\Delta$I$_{ij}$ = I$_i$-I$_j$) de deux valeurs de courant (I$_i$) à chaque fois et les différences de tension ($\Delta$U$_{ij}$ = U$_i$-U$_j$) de deux valeurs de tension ($\Delta$U$_i$) à chaque fois,
- calculer une quantité de quotients différentiels (($\Delta$U/$\Delta$I)$_{ij}$) à chaque fois comme quotient d'une différence de tension et de la différence de courant associée (($\Delta$U/$\Delta$I)$_{ij}$ = $\Delta$U$_{ij}$/$\Delta$I$_{ij}$),
- former la grandeur caractéristique de la résistance différentielle (RD) à partir de la quantité

de quotients différentiels $\left(\left(\dfrac{\Delta U}{\Delta I}\right)_{ij}\right)$, et

- calculer la quantité de charge ($Q_{Rest}$) qui peut encore être prélevée de la batterie d'accumulateurs à partir de la grandeur caractéristique de la résistance différentielle (RD) en utilisant une fonction prédéterminée ou un tableau de valeurs enregistrées pour définir le rapport entre les quantités de charge ($Q_{Rest}$) et les grandeurs caractéristiques de la résistance différentielle (RD).

2. Procédé selon la revendication 1,
   **caractérisé par**
   un calcul de la grandeur caractéristique de la résistance différentielle (RD) en moyennant les quantités de quotients différentiels (($\Delta U/\Delta I)_{ij}$).

3. Procédé selon la revendication 2,
   **caractérisé par**
   une moyenne linéaire.

4. Procédé selon l'une des revendications précédentes,
   **caractérisé en ce qu'**
   au moins un premier instant ($t_1$) est situé dans une phase de repos pendant laquelle la réponse en tension n'est pas marquée par la polarisation et au moins un second instant ($t_2$) est situé dans une phase de polarisation pendant laquelle la réponse en tension est marquée par la polarisation.

5. Procédé selon la revendication 4,
   **caractérisé en ce que**
   le premier instant ($t_1$) est choisi avant une impulsion de courant qui présente un flanc d'impulsion de courant croissant et qui diminue ensuite, et le second instant ($t_2$) est choisi après le flanc d'impulsion de courant croissant de l'impulsion de courant.

6. Procédé selon l'une des revendications précédentes,
   **caractérisé en ce que**
   la grandeur caractéristique de la résistance différentielle (RD) n'est déterminée qu'à partir des paires de valeurs de tension/courant ($U_i$, $I_i$) qui sont mesurées dans un état de charge comparable et/ou une température (T) comparable de la batterie d'accumulateurs.

7. Procédé selon l'une des revendications précédentes,
   **caractérisé par**
   une mesure de la température (T) de la batterie d'accumulateurs et une détermination de la quantité de charge qui peut être prélevée ($Q_{Rest}$) en fonction de la température (T).

8. Procédé selon la revendication 7,
   **caractérisé par**
   une normalisation des quotients différentiels (($\Delta U/\Delta I)_{ij}$) sur une température de base ($T_B$).

9. Procédé selon l'une des revendications précédentes,
   **caractérisé par**
   une alimentation de la batterie d'accumulateurs avec une série d'impulsions de courant, le sens d'écoulement des impulsions de courant changeant alternativement.

10. Procédé selon l'une des revendications précédentes,
    **caractérisé en ce que**
    la somme des valeurs de courant ($I_i$) est inférieure au courant à 10 heures de la batterie d'accumulateurs.

11. Procédé selon la revendication 10,
    **caractérisé en ce que**
    la somme des valeurs de courant ($I_i$) est inférieure au courant à 50 heures de la batterie d'accumulateurs.

12. Procédé selon la revendication 10,
    **caractérisé en ce que**
    la somme des valeurs de courant ($I_i$) est inférieure au courant à 200 heures de la batterie d'accumulateurs.

13. Procédé selon l'une des revendications précédentes
    **caractérisé en ce que**,
    entre deux mesures de deux paires de valeurs de tension/courant ($U_i$, $I_i$), on obtient un changement de courant ($\Delta I$), le changement de courant total ($\Delta I$) étant supérieur à une valeur de courant à 5000 heures de la batterie d'accumulateurs.

14. Procédé selon la revendication 13,
    **caractérisé en ce que**
    le changement de courant total ($\Delta I$) est supérieur à une valeur de courant à 1000 heures de la batterie d'accumulateurs.

15. Procédé selon la revendication 13,
    **caractérisé en ce que**
    le changement de courant total ($\Delta I$) est supérieur à une valeur de courant à 200 heures de la batterie d'accumulateurs.

16. Procédé selon l'une des revendications précédentes,
    **caractérisé en ce que**
    le changement de courant ($\Delta I$) est réalisé à une vitesse de changement de courant $\left(\dfrac{\Delta I}{\Delta t}\right)$ qui, au total, est supérieure au courant à 5 000 heures de la batterie d'accumulateurs, par seconde.

17. Procédé selon la revendication 16,
**caractérisé en ce que**

la vitesse de changement de courant $\left(\dfrac{\Delta I}{\Delta t}\right)$ est supérieure au courant à 1 000 heures, par seconde.

18. Procédé selon la revendication 16,
**caractérisé en ce que**

la vitesse de changement de courant $\left(\dfrac{\Delta I}{\Delta t}\right)$ est supérieure au courant à 200 heures, par seconde.

19. Procédé selon l'une des revendications 4 à 5,
**caractérisé en ce que**
la première paire de valeurs de tension de courant/ courant ($U_1$, $I_1$) est mesurée au premier instant ($t_1$) au plus 10 secondes, de préférence au plus 1 seconde et particulièrement préféré au plus 0,1 seconde juste avant un changement de courant ($\Delta I$).

20. Procédé selon la revendication 19,
**caractérisé en ce que**
la seconde paire de valeurs de tension de courant/ courant ($U_2$, $I_2$) est mesurée au second instant ($t_2$) au plus tôt 0,1 seconde, de préférence au plus tôt 1 seconde et particulièrement préféré au plus tôt 10 secondes après le changement de courant ($\Delta I$).

21. Procédé selon la revendication 20,
**caractérisé en ce que**
les écarts dans le temps entre le changement de courant ($\Delta I$) et la mesure de la seconde paire de valeurs de tension/courant ($U_2$, $I_2$) au second instant ($t_2$) dépendent de la température, l'écart dans le temps étant supérieur pour des températures ($T$) plus élevées que pour des températures ($T$) plus basses.

22. Procédé selon l'une des revendications précédentes,
**caractérisé en ce que**
la grandeur caractéristique de la résistance différentielle (RD) n'est déterminée qu'à partir des paires de valeurs de tension/courant ($U_1$, $I_1$ et $U_2$, $I_2$) mesurées aux deux instants ($t_1$, $t_2$), dont la seconde paire de valeurs de tension/courant ($U_2$, $I_2$) n'a été mesurée que lorsque l'intégrale dans le temps du courant ($I$) qui s'écoule en commençant à l'instant d'un changement de courant ($\Delta I$) après la mesure de la première paire de valeurs de tension/courant ($U_1$, $I_1$) jusqu'au second instant ($t_2$) de la mesure de la seconde paire de valeurs de tension/courant ($U_2$, $I_2$), a au moins une valeur de 0,01 mAs, de préférence de 0,1 mAs et particulièrement préférée d'au moins 1 mAs, pour une ampère-heure de capacité d'accumulation de la batterie d'accumulateurs.

23. Procédé selon l'une des revendications précédentes,
**caractérisé en ce qu'**
on utilise un profil de courant approximativement homogène des impulsions de courant utilisées pour déterminer la grandeur caractéristique de la résistance différentielle (RD), le profil de courant se définissant à partir des vitesses de changement de courant

$\left(\dfrac{\Delta I}{\Delta t}\right)$ du changement de courant entre les paires de valeurs de tension/courant ($U_i$, $I_i$ et $U_j$, $I_j$) utilisées pour la détermination, la durée entre une première paire de valeurs de tension/courant ($U_i$) jusqu'au changement de courant ($\Delta I$) et la durée entre le changement de courant ($\Delta I$) et la seconde paire de valeurs de tension/courant ($U_2$, $I_2$).

24. Procédé selon l'une des revendications précédentes,
**caractérisé en ce que**
les impulsions de courant de la batterie d'accumulateurs sont imposées par une unité de commutation électrique.

25. Procédé selon l'une des revendications précédentes,
**caractérisé par**
une comparaison de la grandeur caractéristique de la résistance différentielle (RD) ou de la quantité de charge ($Q_{Rest}$) qu'il reste à prélever, avec une valeur de seuil, et l'émission d'un dépassement de la valeur de seuil, du rapport de la grandeur caractéristique de la résistance différentielle (RD) ou de la quantité de charge ($Q_{Rest}$) qu'il reste à prélever par rapport à la valeur de seuil, et/ ou de l'écart de la grandeur caractéristique de la résistance différentielle (RD) ou de la quantité de charge ($Q_{Rest}$) qu'il reste à prélever par rapport à la valeur de seuil.

26. Procédé selon la revendication 25,
**caractérisé en ce que**
la valeur de seuil est définie en fonction de la température ($T$) de la batterie d'accumulateurs.

27. Procédé selon l'une des revendications précédentes,
**caractérisé par**

une détermination de toute la capacité d'accumulation actuelle de la batterie d'accumulateurs et/ou de la quantité de charge qui peut être chargée dans la batterie d'accumulateurs en corrélant la quantité de charge calculée qui peut être prélevée ($Q_{Rest}$) avec le degré de décharge actuel (DoD) et/ou l'état de charge actuel (SoC).

28. Procédé selon l'une des revendications précédentes,
**caractérisé par**
une détermination d'une grandeur caractéristique d'usure pour décrire la diminution de la capacité d'accumulation de la batterie d'accumulateurs, en corrélant la capacité d'accumulation globale actuelle déterminée de la batterie d'accumulateurs avec la capacité d'accumulation de la batterie d'accumulateurs à l'état neuf ou avec la valeur nominale de la capacité d'accumulation de la batterie d'accumulateurs à l'état neuf.

29. Procédé selon la revendication 28,
**caractérisé par**
une comparaison de la grandeur caractéristique d'usure avec une valeur de seuil, et la diffusion d'un message de maintenance en fonction de la comparaison.

30. Procédé selon l'une des revendications précédentes,
**caractérisé en ce que**
la batterie d'accumulateurs est un accumulateur au plomb.

31. Procédé selon l'une des revendications précédentes,
**caractérisé par**
une association des résultats de calcul avec d'autres grandeurs d'état de la batterie d'accumulateurs, par exemple avec l'état de charge et/ou le potentiel de la batterie d'accumulateurs et/ou des grandeurs caractéristiques pour des effets entraînant l'usure d'une batterie d'accumulateurs.

32. Procédé selon l'une des revendications précédentes,
**caractérisé par**
une prévision du comportement de la batterie d'accumulateurs dans un autre état de fonctionnement que l'état actuel.

33. Batterie d'accumulateurs comprenant des moyens de mesure et des moyens d'exploitation commandés par un processeur pour réaliser le procédé selon l'une des revendications précédentes.

Fig. 1

Fig. 2

Fig. 3

Fig. 4

Fig. 5

Fig. 6

Fig. 7

Batterie 57083 - Belastung mit kleinen Strömen (0,5A u. 1A)

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5721688 A
- US 5572136 A
- DE 9321638 U1
- US 5680050 A
- DE 69131276 T2
- US 20020030495 A1
- US 4947124 A